# EUROPEAN PATENT SPECIFICATION

(11) **EP 0 110 576 B1**
(45) Date of publication and mention of the grant of the patent: **07.01.1988**
(21) Application number: 83306622.8
(22) Date of filing: 31.10.1983
(51) Int. Cl.: G03F 7/10, C08F 12/16

(54) **Ionizing radiation-sensitive material and its use for preparing a pattern**
Ionisierendes strahlungsempfindliches Material und Verwendung desselben für Musterherstellung
Matériel sensible aux radiations ionisantes et emploi pour la réalisation de patrons

(30) Priority: 29.10.1982 JP 189148/82
(43) Date of publication of application: 13.06.1984
(73) Proprietor: JAPAN SYNTHETIC RUBBER CO., LTD., Tokyo 104 (JP)
(72) Inventor: Harita, Yoshiyuki, Kawasaki-shi (JP); Kamoshida, Yoichi, Midori-ku Yokohama (JP); Takatori, Masashige, Midori-ku Yokohama (JP); Harada, Kunihiro, Machida-shi (JP)
(74) Representative: Tubby, David George

(56) References cited:
- EP-A- 0 005 551
- GB-A- 2 022 855
- US-A- 3 812 061
- US-A- 4 201 580

## Description

The present invention relates to a material which is sensitive to such ionizing radiation as far ultraviolet radiation, electron beams and X-rays, and which material is used as a negative-type resist.

The production of electronic components, such as transistors and integrated circuits, has hitherto been carried out by coating a photoresist on a base, irradiating the photoresist with light through a photo-mask, dissolving the uncrosslinked part of the photoresist in a developer, and then wet-etching the part of the substrate other than the desired pattern. However, when light is used as part of this series of steps, there is a limit to the resolution which is attainable because of the diffraction of the light and, moreover, the wet-etching process has been unable to etch sufficiently fine patterns because of "side etching" (in which some of the etchant goes around the edges of the pattern to its underside and undermines parts of the pattern which should be untouched) and because of the influence of impurities in the etchant. To overcome the former problem, a technique has recently been developed in which high accurate patterns are formed using high energy ionizing radiation, for example far ultraviolet radiation, electron beams, X-rays and the like (which have a short wave-length) in place of light. To overcome the latter problem, there has been developed an etching technique for producing fine patterns not by wet-etching but by a dry-etching method using, for example, gas plasma, reactive ion etching, ion milling or the like.

When it is intended to form a pattern by irradiation with ionizing radiation, followed by dry etching, the resist used must be sufficiently sensitive to ionizing radiation to form a fine pattern with a high degree of accuracy and, at the same time, it must be highly resistant to dry etching. Although polystyrene is known as an example of a resist material which is sensitive to ionizing radiation, it has the fault that its sensitivity to ionizing radiation is still too low.

GB-A-2 022 855 and EP-A-0 005 551 disclose radiation-sensitive polymers used in resists but these differ from those of the present invention in their distribution of halogen atoms. US-A-3 812 061 discloses similar polymers but not as resists.

We have now discovered an ionizing radiation-sensitive material having a high degree of sensitivity to ionizing radiation, which is capable of forming a fine pattern with a good degree of accuracy and which has a high resistance to dry etching.

Thus, the present invention consists in an ionizing radiation-sensitive resist which comprises a polymer (which may be a homopolymer or a copolymer) having a recurring unit represented by the formula (A): 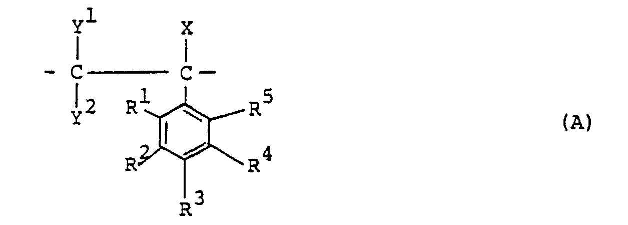 in which: X, Y¹ and Y² are the same or different and each represents a hydrogen atom, a methyl group or a halogen atom; and R¹, R², R³, R⁴ and R⁵, which may be the same or different, each represents a hydrogen atom, a halogen atom, a C₁-C₃ alkyl group, a C₁-C₃ alkoxy group, a C₁-C₃ haloalkyl group or a C₁-C₃ haloalkoxy group, at least some of the groups represented by X and at least some of the groups Y¹ and/or Y² in said polymer being halogen atoms and at least some of the groups represented by R¹, R², R³, R⁴ and R⁵ in said polymer being a haloalkyl or a haloalkoxy group, said polymer having a halogen content of from 1 to 50% by weight.

In the polymer employed in the present invention, the proportion of the number of recurring units represented by the aforementioned formula (A) in which X represents a halogen atom [hereinafter referred to as "recurring units (A-1 )"] is preferably from 2 to 25%, more preferably from 5 to 20%. The proportion of the number of recurring units represented by the aforementioned formula (A) in which one or more of the groups represented by R¹, R², R³, R⁴ and R⁵ is a haloalkyl or a haloalkoxy group [hereinafter referred to as "recurring units (A-2)"] is preferably from 3 to 40%, and more preferably from 5 to 35%. The proportion of the number of recurring units represented by the aforementioned formula (A) in which one or more of the groups represented by Y¹ and/or ^{y2} is a halogen atom [hereinafter referred to as "recurring units (A-3)"] is preferably from 2 to 25%, more preferably from 5 to 20%. The percentages of units (A-1), (A-2) and (A-3) are based on the total number of recurring units in the polymer. If the proportion of the number of recurring units (A-1) increases, the resistance to dry etching increases; if the proportion of the number of recurring units (A-2) increases, the sensitivity to ionizing radiation increases; and the proportion of units (A-3) contributes to enhancement of resulution. We prefer that the sum of the percentages of recurring units (A-1), (A-2) and (A-3) should be from 7 to 70%, more preferably from 9 to 60%, based on the total number of recurring units in the polymer, although the total sum may vary depending on the method of synthesis.

The total halogen content of the polymer is from 1 to 50% by weight, preferably from 1 to 45% by weight, and more preferably from 1 to 25% by weight.

When X-rays are used as the ionizing radiation, a relatively highly halogenated product is preferred to enhance absorption of the X-rays. In this case, the total halogen content of the polymer is preferably from 5 to 50% by weight. The percentage halogen contents given herein are based on the total weight of the polymer.

For the purposes of the present invention, a recurring unit represented by the aforementioned formula (A) in which the group represented by X is a halogen atom, one or more of the groups represented by R¹, R², R³, R⁴ and R⁵ is a haloalkyl or haloalkoxy group and at least one of Y¹ and Y² is a halogen atom is counted thrice, once as a recurring unit (A-1), once as a recurring unit (A-2), and once as a recurring unit (A-3). Similarly, for example, a recurring unit in which X and at least one of Y¹ and Y² represent halogen atoms, whilst R¹, R², R³, R⁴ and R⁵ represent hydrogen atoms, alkyl groups, alkoxy groups or halogen atoms is counted twice, once as a recurring unit (A-1) and once as a recurring unit (A-3).

In the recurring units represented by formula (A), we prefer that R¹, R², R³, R⁴ and R⁵ should each represent a hydrogen atom, a methyl group, an ethyl group, a propyl group, a methoxy group, an ethoxy group, a propoxy group, a chlorine atom, a bromine atom, an iodine atom, a fluorine atom, a chloromethyl group, a bromomethyl group, a chloroethyl group, a chloropropyl group, a chloromethoxy group, an iodomethoxy group, a bromomethoxy group, an iodopropyl group, a chloroethoxy group, a chloropropoxy group, a dichloromethyl group, a dibromomethyl group, a diiodomethyl group, a dichloroethyl group, a dibromoethyl group, a dichloropropyl group, a dibromopropyl group, a dichloromethoxy group, a dibromomethoxy group, a diiodomethoxy group, a dichloroethoxy group, a dibromoethoxy group, a dichloropropoxy group, a dibromopropoxy group, a trichloromethyl group, a tribromomethyl group, a trichloroethyl group, a tribromoethyl group, a trichloromethoxy group or a tribromomethoxy group. We particularly prefer that one of the groups represented by R¹, R², R³, R⁴ and R⁵ should be a methyl, chloromethyl, bromomethyl, dichloromethyl or dibromomethyl group and the others should be hydrogen atoms.

In the recurring units of formula (A), where X, Y¹ and Y² represent halogen atoms, they are preferably chlorine, bromine, fluorine and iodine atoms and the atoms represented by X, Y¹ and Y² may be the same or different. The polymer may contain two or more different kinds of halogen atom.

Other recurring units which can form a copolymer in combination with the recurring unit or units represented by formula (A) include: units derived from ethylenically unsaturated compounds, such as ethyl acrylate, butyl acrylate, glycidyl acrylate, ethyl methacrylate, butyl methacrylate, glycidyl methacrylate, a-vinylnaphthalene, β-vinylnaphthalene, 2-vinylpyridine, 4-vinylpyridine, maleic anhydride and vinyl acetate; units derived from conjugated dienes, such as butadiene or isoprene; and halogenated units corresponding to the aforementioned ethylenically unsaturated and conjugated diene units. However, the proportion of the number of other such recurring units is preferably less than 50% and more preferably less than 20%, based on the total number of recurring units in the copolymer, in order to achieve adequate sensitivity of the copolymer to ionizing radiation and adequate resistance to dry etching.

The molecular weight of the polymer employed in the present invention is not critical, although a higher molecular weight is preferred in order to achieve high sensitivity to ionizing radiation, whereas a lower molecular weight is preferred in order to facilitate handling when forming a resist film. The range of number average molecular weights satisfying these two contradictory requirements is preferably from 10,000 to 1,500,000, and more preferably from 10,000 to 1,000,000, as measured by a membrane osmometer.

The polymer employed in the present invention may be prepared, for example, by polymerizing a monomeric material comprising at least one monomer of formula (B): 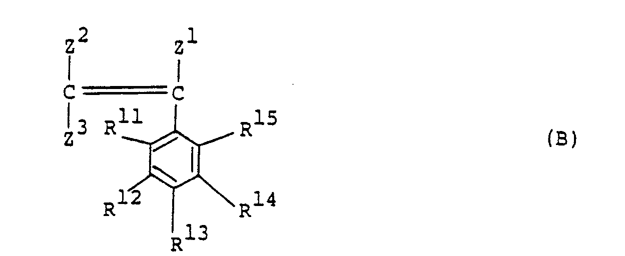 (wherein: R¹¹, R¹², R¹³, R¹⁴ and R¹⁵, which may be the same or different, each represents a hydrogen atom, a C₁-C₃ alkyl group or a C₁-C₃ alkoxy group, provided that R", R¹², R¹³, R¹⁴ and R¹⁵ do not all simultaneously represent hydrogen atoms; and Z¹, Z² and Z³ are the same or different and each represents a hydrogen atom, a fluorine atom or a methyl group, provided that when Z¹ represents a methyl group, Z² and Z³ both represent hydrogen atoms), optionally together with at least one monomer of formula (C): 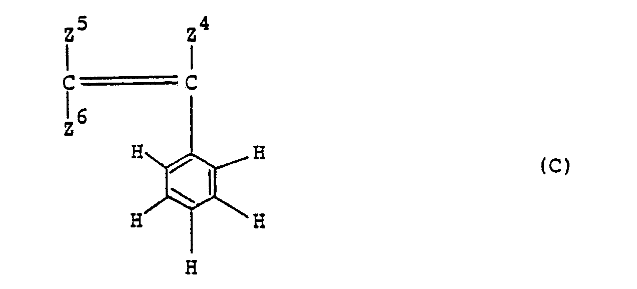 (wherein Z⁴, Z⁵ and Z⁶ are the same or different and each represents a hydrogen atom, a fluorine atom, or a methyl group, provided that, when Z¹ in the general formula (B) represents a methyl group, Z4 represents a hydrogen atom) and halogenating it with a halogenating reagent under free radical conditions, for instance, in the presence of a radical-generating agent or under irradiation with light or ultraviolet rays, to form a halogenated polymer having a halogen content of from 1 to 50% by weight.

Two preferred embodiments (1) and (2) of this production process are given below.

(1) A process which comprises polymerizing a monomeric material comprising at least one monomer represented by the general formula (D): 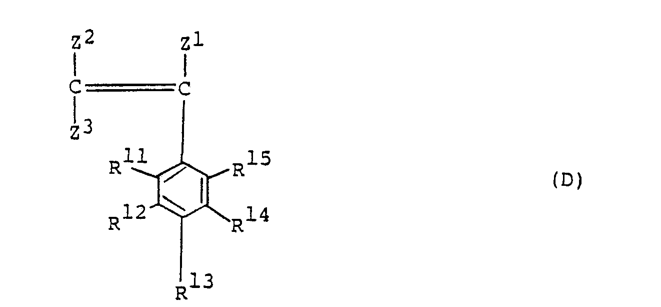 [wherein R¹¹, R¹², R¹³, R¹⁴, R¹⁵, Z¹, Z² and Z³ have the same meanings as defined in the general formula (B)], or a monomeric material comprising at least one monomer represented by the general formula (D) and at least one monomer represented by the general formula (E): 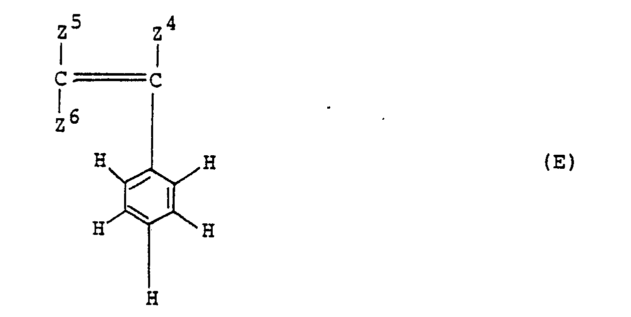 [wherein Z⁴, Z⁵ and Z⁶ have the same meanings as defined in the general formula (C)], and subsequently, radically halogenating the resulting polymer, in the form of a solution in a solvent or swollen with a solvent, with a compound having a halogen radical-generating ability (such as t-butyl hypochlorite, t-butyl hypoiodite, chlorine or bromine) in the presence of a radical-generating agent (such as 4,4'-azobisisobutyronitrile, benzoyl peroxide or lauroyl peroxide) or under irradiation with light or ultraviolet-rays as described in, for example, the Journal of Americal Chemical Society, Vol. 82, 108 (1960).
(2) A process which comprises polymerizing a monomeric material comprising at least one monomer represented by the general formula (D) or a monomeric material comprising at least one monomer represented by the general formula (D) and at least one monomer represented by the general formula (E), and subsequently, radically halogenating the resulting polymer, in the form of a solution in a solvent or swollen with a solvent, with an N-halogenated compound (such as N-chlorosuccinimide, N-bromosuccinimide or N-bromoacetamide) in the presence of the said radical-generating agent or under irradiation with light or ultraviolet-rays as described in, for example, the Journal of American Chemical Society, Vol. 74, 2189 (1952).

Examples of monomers which may be represented by general formula (D) and which can be used to prepare the polymer employed in the present invention include o-methylstyrene, m-methylstyrene, p-methylstyrene, p-ethylstyrene, o-ethylstyrene, m-ethylstyrene, p-methoxystyrene, o-methoxystyrene, m-methoxystyrene, a-methyl-p-methylstyrene and a-methyl-p-methoxystyrene. A single one of these monomers or a combination of any two or more of them may be used. Examples of monomers which may be represented by general formula (E) include a-methylstyrene and styrene itself. Again, a single one of these monomers may be used or two or more of them may be used.

Examples of monomers which may be polymerized in addition to the monomers represented by general formulae (D) and (E) include, for example: acrylic esters, such as ethyl acrylate, butyl acrylate, or glycidyl acrylate; methacrylic esters, such as ethyl methacrylate, butyl methacrylate or glycidyl methacrylate; aromatic vinyl compounds other than the monomers represented by general formulae (D) and (E), such as a-vinylnaphthalene, β-vinylnaphthalene, 2-vinylpyridine or 4-vinylpyridine; maleic anhydride; vinyl acetate; and conjugated dienes, such as butadiene or isoprene.

The proportion of recurring units of formulae (B) to the total recurring units in the polymer from which the polymer of the invention is prepared is preferably from 20 to 100%, more preferably from 30 to 100%, in order to enhance the sensitivity of the polymer of the invention to ionizing radiation. The proportion of recurring units represented by general formula (C) to the total number of recurring units in the initial polymer from which the polymer of the invention is prepared is preferably from 0 to 80%, more preferably from 0 to 70%. The number average molecular weight of this initial polymer is preferably from 8,000 to 150,000, more preferably from 8,000 to 100,000.

In processes (1) and (2), the solvent used in the halogenation reaction is preferably a solvent which does not interact with halogen radicals. For this reason, we particularly prefer to use benzene or a halogenated hydrocarbon, such as carbon tetrachloride, carbon tetrabromide or 1,1,2-trichloroethane.

In order to achieve a polymer having the desired degree of halogenation, it is generally necessary to control the halogenation in both Processes (1) and (2). In Process (1), the degree of halogenation is generally controlled by varying the amount of the compound which is capable of generating halogen radicals. In Process (2), it is controlled by varying the amount of the N-halogenated compound.

For both Processes (1) and (2), the reaction conditions are as follows. The concentration in the reaction mixture of polymer to be halogenated is preferably from 3 to 20% by weight. When a radical-generating agent is used, the amount of said agent is preferably from 0.01 to 5 parts by weight, per 100 parts by weight of the polymer to be halogenated. The reaction'temperature is preferably from 40°C to 200°C.

When halogenating under the influence of light or ultraviolet radiation, the intensity of the light or ultraviolet radiation may be varied, depending upon the desired degree of halogenation.

In order to stabilize the polymer having recurring units of formula (A), a stabilizer may be incorporated in an amount of from 0.5 to 5% by weight. Examples of suitable stabilizers include: hydroxyaromatic compounds, such as hydroquinone, methoxyphenol, p-t-butylcatechol, and 2,2'-methylenebis(6-t-butyl-4-ethylphenol); quinones such as benzoquinone, p-toluquinone, and p-xyloquinone; amines such as phenyl- a-naphthylamine, and p,p'-diphenylphenylenediamine; and sulphur compounds, such as dilauryl thiodipropionate, 4,4'-thiobis(6-t-butyl-3-methylphenol), 2,2'-thiobis(6-t-butyl-4-methylphenol) and 2-(3,5-di-t-butyl-4-hydroxyanilino)-4,6-bis(N-octylthio)-s-triazine.

The process of the present invention for forming patterns employing the ionizing radiation sensitive material of the present invention preferably comprises the steps:
(1) forming a coating film of the ionizing radiation-sensitive material on a substrate, preferably using the material in the form of an organic solvent solution, by forming a film of the solution and then removing the solvent;
(2) irradiating the desired parts of the coating film with ionizing radiation;
(3) treating the coating film with a developing agent; and
(4) treating the coating film with a rinsing agent.

In step (1), the organic solvent used is preferably a petroleum fraction, such as xylene, ethylbenzene, or toluene. The concentration of the ionizing radiation-sensitive material in the solution cannot be specified generally, as it is determined in accordance with the thickness of the film to be formed, however, we generally employ a solution having a concentration of from 5 to 30% by weight.

In step (2), the amount of ionizing radiation employed will vary depending upon the chemical structure, molecular weight and the like of the ionizing radiation-sensitive material and thus cannot be determined uniquely. However, as is well known in the art, the irradiation is effected until the desired parts of the coating film have been sufficiently cross-linked.

In step (3), the treatment with the developing agent is designed to dissolve the uncrosslinked portions of the coating film and remove them from the film. This developing agent may be any good solvent for dissolving the ionizing radiation-sensitive material and its nature is not particularly critical. The solvent is preferably an organic solvent, such as benzene, toluene, xylene, cyclohexane, ethylcyclohexane, decahydronaphthalene (e.g. that sold under the Trade Mark "DECALIN"), ethylene glycol monoethyl ether acetate, methyl ethyl ketone, methyl isobutyl ketone, isoamyl acetate, 2-nitropropane or 1,1,2-trichloroethane or an organic solvent comprising one or more of these as the major component. The temperature at which the film is treated with the developing agent is usually from 20°C to 30°C and the time required is generally from 5 seconds to 5 minutes.

In step (4), treatment with the rinsing agent is designed to extract the developing agent from cross-linked parts of the coating film which have been swollen by the developing agent. The nature of the rinsing agent is not critical, although it should be compatible with the developing agent and should also be a poor solvent for the ionizing radiation-sensitive material. Suitable liquids which may be used as the rinsing agent include, for example, alcohols and organic solvents containing at least 10% by weight of an alcohol having from 1 to 6 carbon atoms. Suitable such alcohols include isobutanol, t-butanol, heptanol, 2-butanol, ethanol, methanol, ethylene glycol and amyl alcohol. In addition, these alcohols may be used in admixture with one or more of the same solvents as are exemplified above for use as the developing agent. The temperature for treatment with the rinsing agent is usually from 20°C to 30°C and the time required is usually from 5 seconds to 5 minutes. The rinsing treatment may be conducted twice or thrice, using different rinsing agents.

When the ionizing radiation-sensitive material employed and the process conditions are in accordance with the preferred embodiments described above, it is possible to form a fine pattern with a high degree of accuracy and with a high resistance to dry etching.

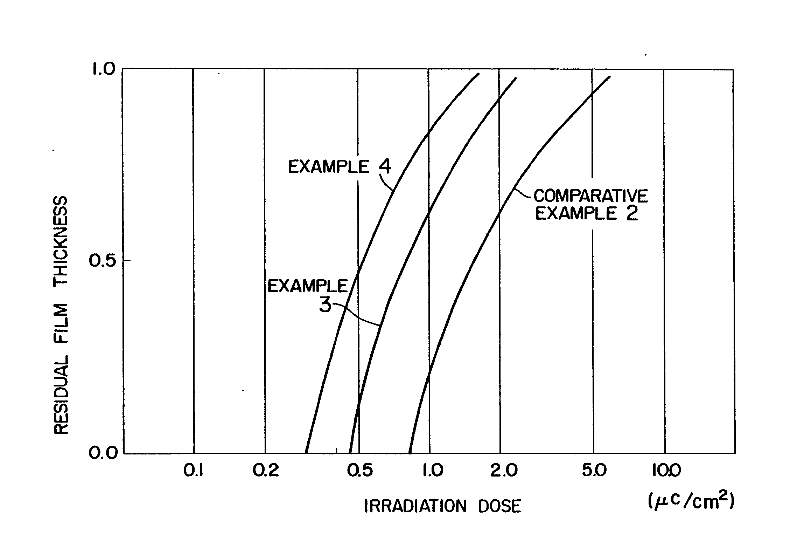

The invention is further illustrated by the following Examples and with reference to the accompanying drawing, which shows the characteristic curve showing the sensitivity of the coating film obtained in Examples 3 and 4 and Comparative Example 2. However, the Examples are merely by way of illustration and not by way of limitation.

### Example 1

A magnetic stirrer was introduced into a round-bottom flask, and the air in the flask was replaced with nitrogen. Under a stream of nitrogen, 320 g of cyclohexane and 35.4 g of p-methyl styrene were introduced to form a homogeneous solution, and then the temperature of the solution was kept at 50°C. Subsequently, under a stream of nitrogen, 0.80 ml of a 0.50 mole/liter solution of n-butyllithium in cyclohexane was added to initiate the polymerization. The polymerization conversion reached 91.5% in 120 minutes. The resulting reaction mixture was poured into methanol containing 2,6-di-t-butyl-p-cresol to recover p-methylstyrene polymer. It was dried under reduced pressure at 40°C for 16 hours. In a round-bottom flask was placed 11.8 g of the dried polymer, and the air in the flask was replaced with nitrogen, after which 224 g of carbon tetrachloride, 96 mg of 4,4'-azobisisobutyronitrile and 3.5 g of t-butyl hypochlorite were added and the resulting mixture was subjected to reaction for 90 minutes while keeping the temperature of the mixture at 70°C. The reaction mixture was poured into methanol containing 2,2'-methylene-bis(6-t-butyl-4-methylphenol) to separate the product which was then recovered. By analyzing the product by means of a'H-nuclear magnetic resonance apparatus (JNM-4H-100, manufactured by Nippon Denshi), it was found that the peak due to the hydrogen of methyl group in the vicinity of 5 = 2.2 ppm and the peak due to the hydrogen of methine group in the vicinity of δ = 1.8 ppm, which were seen in the starting polymer, became small. Moreover, by analyzing the product by means of a 13C-nuclear magnetic resonance apparatus (JNM-FX-100, manufactured by Nippon Denshi), absorption due to chloromethyl group was newly observed at δ = 46.1 ppm and further absorptions due to 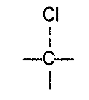 and due to 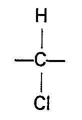 were observed at 5 = 68-76 ppm and δ = 51-55 ppm, respectively. From this fact, it was confirmed that the methyl group in the polymer and the methylene and methine groups in the main chain were chlorinated. Analyzing in detail these nuclear magnetic resonance spectra, the recurring units (A-1), (A-2) and (A-3) were confirmed to be contained in proportions of 7.5%, 16% and 6.5%, respectively. Furthermore, the chlorine content was 8.3% by weight and the number average molecular weight was 4.5 x 10⁵ as measured by a membrane osmometer.

The product obtained above was dissolved in xylene to form a 6.5% by weight solution. The solution was put on a silicon wafer having a thermally oxidized layer (0.7 µm in thickness), and the assembly was rotated first at 200 r.p.m. for 2 seconds and subsequently at 4,000 r.p.m. for 30 seconds to coat the solution on the wafer. The solvent was volatilized away by a heat-treatment at 80°C for 30 minutes to obtain a coating film having a thickness of 0.5 µm formed on the wafer. After irradiating it with deep ultraviolet rays through a mask by means of an exposer (PLA-521 F, manufactured by CANON, INC.), it was developed with Cellosolve acetate for 1 minute and then rinsed with a mixed solution of methyl ethyl ketone and isopropyl alcohol (1:1 by volume) for 1 minute. As a result, it was found that an image of 0.6 _{Il}m could be resolved with a high fidelity to mask at an irradiation energy of 6.8 mJ/cm^{z.}

### Example 2

A magnetic stirrer was placed in a round-bottom flask, and the air in the flask was replaced with nitrogen. Under a stream of nitrogen, 577 g of cyclohexane, 49.9 g of styrene and 14.2 g of o-methylstyrene were introduced into the flask to form a homogeneous solution, after which the temperature of the solution was kept at 60°C. Subsequently, under a stream of nitrogen, 2.4 ml of a 0.25 mole/liter solution of n-butyllithium in cyclohexane was added to the solution to initiate the polymerization. The polymerization conversion reached 100% in 60 minutes. Thus, the reaction mixture was poured into methanol containing 2,2'-methylene-bis(6-t-butyl-4-ethylphenol) to recover the resulting styrene-o-methylstyrene copolymer. The copolymer was dried under reduced pressure at 40°C for 16 hours. Then, 10.7 g of the copolymer thus obtained was placed in a round-bottom flask and the air in the flask was replaced with nitrogen, after which 224 g of 1,1,2-trichloroethane, 96 mg of 4,4'-azobisisobutyronitrile and 4.2 g of N-chlorosuccinimide were added and the resulting solution was subjected to reaction for 1.5 hours while keeping the temperature of the solution at 70°C. The reaction product was poured into methanol containing 2,2'-methyiene-bis(6-t-butyl-4-ethylphenol) to separate the product, which was then recovered. Its chlorine content was 7.0% by weight.

Analyzing the structure of the product in the same manner as in Example 1, it was confirmed that the recurring units (A-1), (A-2) and (A-3) were contained in proportions of 8.5%, 12% and 7.5%, respectively. Furthermore, the chlorine content was 8.5% by weight and the number average molecular weight ws 2.3 x 10⁵ as measured by a membrane osmometer.

The product obtained above was dissolved in xylene to form an 8.5% by weight solution. The solution was put on a silicon wafer having a thermally oxidized layer (0.7 µm in thickness) and the assembly was rotated first at 200 r.p.m. for 2 seconds and subsequently at 4,000 r.p.m. for 30 seconds to coat the wafer with the solution. The solvent was volatilized away by a heat-treatment at 80°C for 30 minutes to obtain a coating film having a thickness of 0.5 pm formed on the wafer. After irradiating it with deep ultraviolet rays through a mask using an exposer, it was developed with Cellosolve acetate for 1 minute and then rinsed with a mixed solution of methyl ethyl ketone and isopropyl alcohol (1:1 by volume) for 1 minute. As a result, it was found that an image of 0.6 pm was resolved with a high fidelity to mask at a deep ultraviolet irradiation energy of 7.8 mJ/cm².

### Example 3

In the same manner as in Example 1, a coating film having a thickness of 0.5 µm was formed on silicon wafer having a thermally oxidized layer. Subsequently, the resulting assembly was irradiated with electron beams at an acceleration voltage of 20 kV, developed with Cellosolve acetate for 1 minute, and then rinsed with a mixed solution of methyl ethyl ketone and isopropyl alcohol (1:1 by volume) for 1 minute. As a result, the irradiation energy of the electron beams at the gel point was 0.45 µC/cm², and the characteristic curve regarding sensitivity (relation between the yield of residual resist thickness and the irradiation energy) was as shown in the accompanying drawings.

### Example 4

A magnetic stirrer was introduced into a round-bottom flask, and the air in the flask was replaced with nitrogen. Under a stream of nitrogen, 320 g of cyclohexane and 35.4 g of p-methylstyrene were introduced to form a homogeneous solution, and then the temperature of the solution was kept at 50°C. Subsequently, under a stream of nitrogen, 0.11 ml of a 0.25 mole/liter solution of n-butyllithium in cyclohexane was added to initiate the polymerization. The polymerization conversion reached 99% in 120 minutes. The resulting reaction mixture was poured into methanol containing 2,6-di-t-butyl-p-cresol to recover p-methylstyrene polymer. It was dried under reduced pressure at 40°C for 16 hours. In a round-bottom flask was placed 11.8 g of the dried polymer, and the air in the flask was replaced with nitrogen, after which 150 ml of 1,1,2-trichloroethane, 95 mg of 4,4'-azobisisobutyronitrile and 4.0 g of t-butyl hypochlorite were added and the resulting mixture was subjected to reaction for 90 minutes while keeping the temperature of the mixture at 70°C. The reaction mixture was poured into methanol containing 2,2'-methylene-bis(6-t-butyl-4-methylphenol) to separate the product which was then recovered.

Analyzing the structure of the product in the same manner as in Example 1, it was confirmed that the recurring units (A-1), (A-2) and (A-3) were contained in proportions of 8%, 18% and 7%, respectively. The number average molecular weight of the product was 3 x 10⁵ as measured by a membrane osmometer, and the chlorine content was 9.1% by weight. Using the product obtained above, a coating film having a thickness of 0.5 _{Il}m was formed on a silicon wafer having a thermally oxidized layer in the same manner as in Example 1, and was tested on electron beam irradiation characteristics. The coated silicon wafer was irradiated with electron beam at an acceleration voltage of 20 kV, and thereafter, development with Cellosolve acetate was conducted for 1 minute, and rinsing with a mixed solution of methyl ethyl ketone and isopropanol (1:1 by volume) was conducted for 1 minute. The characteristic curve regarding sensitivity of the coating film obtained is shown in the accompanying drawings. The irradiation energy at the gel point upon irradiation with electron beam was 0.3 µC/cm².

### Example 5

The image formed by irradiating with deep ultraviolet rays at 6.8 mJ/cm² in Example 1, the image formed by irradiating with deep ultraviolet rays at 7.8 mJ/cm² in Example 2, and the image formed by irradiating with electron beams at an acceleration voltage of 20 kV at 1.0 µC/cm2 in Example 4 were subjected to reactive ion etching and the conditions that the power was 100 W, and the gas pressure was 15 Pa using tetrafluorocarbon/oxygen (95/5 volume ratio) as an etching gas in a parallel plate dry etching reactor to investigate the resistance to dry etching. The relative etch rates when the etch rate of the resist image formed by using the commercially available polymethyl methacrylate electron beam resist was assumed as 1.0 are shown in Table 1.

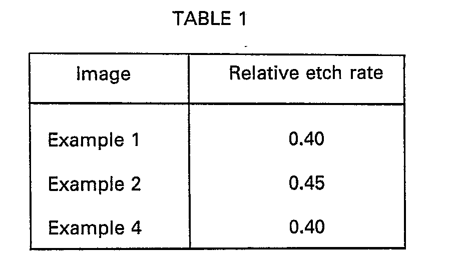

### Example 6

A magnetic stirrer was introduced into a round-bottom flask, and the air in the flask was replaced with nitrogen. Under a stream of nitrogen, 320 g of cyclohexane and 35.4 g of p-methyl styrene were introduced to form a homogeneous solution, and then the temperature of the solution was kept at 50°C. Subsequently, under a stream of nitrogen, 0.60 ml of a 0.50 mole/liter solution of n-butyllithium in cyclohexane was added to initiate the polymerization. The polymerization conversion reached 92.0% in 120 minutes. The resulting reaction mixture was poured into methanol containing 2,6-di-t-butyl-p-cresol to recover p-methylstyrene polymer. It was dried under reduced pressure at 40°C for 16 hours. In a round-bottom flask was placed 11.8 g of the dried polymer, and the air in the flask was replaced with nitrogen, after which 236 g of benzene, 96 mg 4,4'-azobisisobutylronitrile and 10.9 g of t-butyl hypochlorite were added and the resulting mixture was subjected to reaction for 90 minutes while keeping the temperature of the mixture at 70°C. The reaction mixture was poured into methanol containing 2,2'-methylene-bis(6-t-butyl-4-methylphenol) to separate the product which was then recovered. By analyzing the product by means of a ¹H-nuclear magnetic resonance apparatus (JNM-4H-100, manufactured by Nippon Denshi), it was found that the peak due to the hydrogen of methyl group in the vicinity of 5 = 2.2 ppm and the peak due to the hydrogen of methine group in the vicinity of 6 = 1.8 ppm, which peaks were observed in the starting polymer, became small. Furthermore, by analyzing the product by means of ¹³C-nuclear magnetic resonance apparatus (JNM-FX-100, manufactured by Nippon Denshi), absorption due to chloromethyl group was newly observed at 6 = 46.1 ppm, and absorption due to dichloromethyl group was also observed at 6 = 71.8 ppm. Moreover, there was also observed broad absorption due to 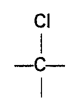 at δ = 76 ppm and absorption due to 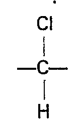 at 6 = 51-55 ppm. From this fact, it was confirmed that the methyl group of the polymer and methylene and methine groups in the main chain had been chlorinated. Therefore, it was confirmed that the resulting polymer contained the following recurring units belonging to the recurring units (A-1), (A-2) and (A-3):

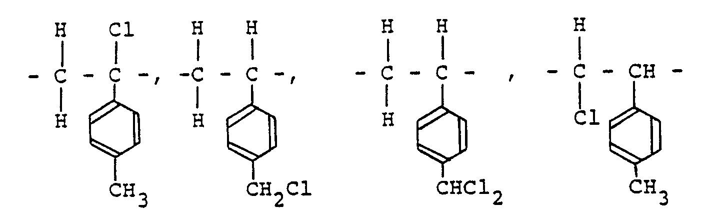

Further, the chlorine content was 20.9% by weight and the number average molecular weight was 6.0 x 10⁵ as measured by a membrane osmometer.

The product obtained above was dissolved in xylene to prepare a 4.8% by weight solution, and this solution was placed on a silicon wafer having a thermally oxidized layer having a thickness of 0.7 pm, and coating was conducted by rotating the silicon wafer at 200 rpm for 2 sec and subsequently at 4,000 rpm for 30 sec. Further, the coated silicon wafer was heat-treated at 80°C for 30 min. to volatilise the solvent away, upon which a coating film having a thickness of 0.5 11m was formed on the wafer. This sample was irradiated through a mask with aluminum Ka rays as the X-rays, and then developed with Cellosolve acetate for 1 min, and subsequently rinsed with a mixed solution of methyl ethyl ketone/isopropanol (1:1 by volume) for 1 min. As a result, it was found that an image having a line width of 0.6 ^{p}m was resolved with a fidelity to the mask at an X-rays irradiation energy of 14 mJ/cm².

### Example 7

A magnetic stirrer was introduced into a round-bottom flask, and the air in the flask was replaced with nitrogen. Under a stream of nitrogen, 320 g of cyclohexane and 35.4 g of p-methylstyrene were introduced to form a homogeneous solution, and then the temperature of the solution was kept at 50°C. Subsequently, under a stream of nitrogen, 0.45 ml of a 0.25 mole/liter solution of n-butyllithium in cyclohexane was added to initiate the polymerization. The polymerization conversion reached 100% in 120 minutes. The resulting reaction mixture was poured into methanol containing 2,6-di-t-butyl-p-cresol to recover p-methylstyrene polymer. It was dried under reduced pressure at 40°C for 16 hours. In a round-bottom flask was placed 11.8 g of the dried polymer, and the air in the flask was replaced with nitrogen, after which 236 g of benzene, 96 mg of 4,4'-azobisisobutyronitrile and 4.1 g of t-butyl hypochlorite were added and the resulting mixture was subjected to reaction for 90 minutes while keeping the temperature of the mixture at 70°C. The reaction mixture was poured into methanol containing 2,2'-methylene-bis(6-t-butyl-4-methylphenol) to separate the product which was then recovered.

In the same manner as in Example 6, the structure of the product was analyzed to confirm that the product contained the following recurring units belonging to the recurring units (A-1), (A-2) and (A-3):

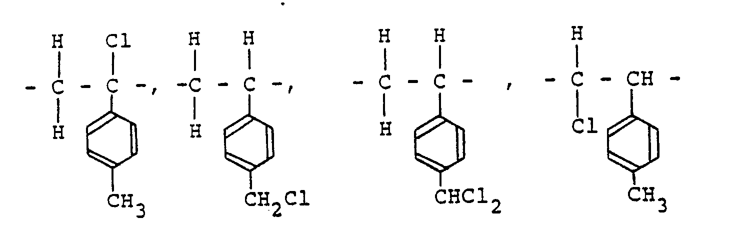

The chlorine content was 9,0% by weight, and the number average molecular weight was 4.0 x 10⁵ as measured by a membrane osmometer.

The product obtained above was dissolved in xylene to prepare a 5.5% by weight solution, and this solution was placed on a silicon wafer having a thermally oxidized layer having a thickness of 0.7 pm, and coating was conducted by rotating the silicon wafer at 200 rpm for 2 sec and subsequently at 4,000 rpm for 30 sec. The thus coated silicon wafer was heat-treated at 80°C for 30 min. to volatilize the solvent away, upon which a coating film having a thickness of 0.5 pm was formed on the wafer. This sample was irradiated through a mask with aluminum Ka rays as the X-rays, thereafter developed with cellosolve acetate for 1 min, and then rinsed with a mixed solution of methyl ethyl ketone and isopropanol (1:1 by volume) for 1 min. As a result, it was found that an image having a line width of 0.6 µm was resolved with a fidelity to the mask at an X-rays irradiation energy of 40 mJ/cm^{2.}

### Example 8

A magnetic stirrer was introduced into a round-bottom flask, and the air in the flask was replaced with nitrogen. Under a stream of nitrogen, 577 g of cyclohexane, 49.9 g of styrene and 14.2 g of o-methylstyrene were introduced to form a homogeneous solution, and then the temperature of the solution was kept at 60°C. Subsequently, under a stream of nitrogen, 2.4 ml of a 0.25 mole/liter solution of n-butyllithium in cyclohexane was added to initiate the polymerization. The polymerization conversion reached 100% in 60 minutes. The resulting reaction mixture was poured into methanol containing 2,6-di-t-butyl-p-cresol to recover styrene-o-methylstyrene copolymer. It was dried under reduced pressure at 40°C for 16 hours. In a round-bottom flask was placed 10.7 g of the dried copolymer, and the air in the flask was replaced with nitrogen, after which 230 g of benzene, 96 mg of 4,4'-azobisisobutyronitrile and 20.0 g of N-chlorosuccinimide were added and the resulting mixture was subjected to reaction for 90 minutes while keeping the temperature of the mixture at 70°C. The reaction mixture was poured into methanol containing 2,2'-methylene-bis(6-butyl-4-methylphenol) to separate the product which was then recovered.

In the same manner as in Example 6, the structure of the product was analyzed, to find that the product containing the following recurring units belonging to the recurring units (A-1), (A-2) and (A-3):

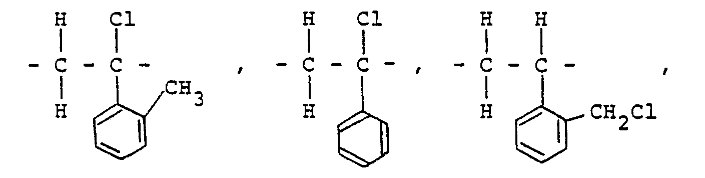

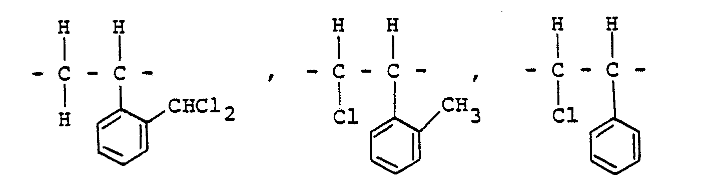

The chlorine content was 28.8% by weight, and the number average molecular weight was 3.0 x 10⁵ as measured by a membrane osmometer.

The product obtained above was dissolved in xylene to prepare a 8.5% by weight solution, and this solution was placed on a silicon wafer having a thermally oxidized layer having a thickness of 0.7 Ilm, and coating was conducted by rotating the silicon wafer at 200 rpm for 2 sec and then at 4,000 rpm for 30 sec. The coated silicon wafer was further heat-treated at 80°C for 30 min to volatilize the solvent away, upon which a coating film having a thickness of 0.5 Ilm was formed on the water. This sample was irradiated through a mask with aluminum Ka-rays as the X-rays, thereafter developed with Cellosolve acetate for 1 min and then rinsed with a mixed solution of methyl ethyl ketone and isopropanol (1:1 by volume) for 1 min. As a result, it was confirmed that an image having a line width of 0.6 pm was resolved with a fidelity to the mask at an X-rays irradiation energy of 13 mJ/cm².

### Example 9

In the same manner as in Example 5, the dry etching resistance of the resist patterns obtained in Examples 6 to 8 was tested, to obtain the results shown in Table 2.

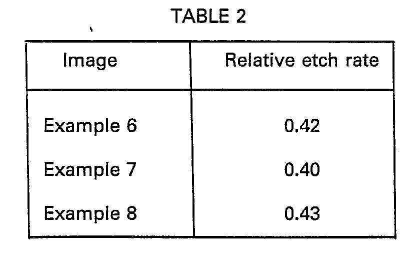

### Comparative Example 1

A magnetic stirrer was placed into a round-bottom flask and the air in the flask was replaced with nitrogen. Under a stream of nitrogen, 481 g of cyclohexane and 52 g of styrene were introduced to form a homogeneous solution, after which the temperature of the solution was kept at 60°C. Subsequently, under a stream of nitrogen, 1.42 ml of a 0.25 mole/liter solution of n-butyllithium in cyclohexane was added to initiate the polymerization. The reaction temperature rose to 70.5°C, and the polymerization conversion reached 100% in 120 minutes. Thus, the reaction mixture was poured into methanol containing 2,2'-methylene-bis(6-t-butyl-4-ethylphenol) to recover the styrene polymer. The polymer was dried under reduced pressure at 40°C for 16 hours. Then, 10.4 g of the polymer thus obtained was introduced into a round-bottom flask and the air in the flask was replaced with nitrogen, after which 224 g of carbon tetrachloride, 9.7 mg of benzoyl peroxide and 6.0 g of t-butyl hypochlorite were added to the flask and the resulting solution was subjected to reaction for 4 hours while keeping the temperature of the solution at 90°C. The reaction mixture was poured into methanol containing 2,2'-methylene-bis(6-t-butyl-4-ethylphenol) to separate the product, which was then recovered.

In the same manner as in Example 1, the structure of the product was analyzed to find that 61 % of the styrene unit, 21% of the recurring unit (A-1), and 18% of the recurring unit (A-3) were contained. The chlorine content was 11.8% by weight and the number average molecular weight was 6.5 x 10⁵ as measured by a membrane osmometer.

The product obtained above was formed into a solution in the same manner as in Example 1, and then the solution was coated on a silicon wafer having a thermally oxidized layer by the same procedure as in Example 1. Further, it was irradiated with deep ultraviolet rays, developed and rinsed in the same manner as in Example 1. As a result, an image of 5 µm or more could barely be resolved at a radiation energy of 65 mJ/cm²_{.}

### Comparative Example 2

A styrene polymer was prepared in the same manner as in Comparative Example 1, except that the amount of 0.25 mole/liter solution of n-butyllithium in cyclohexane used was varied from 1.42 ml to 2.4 ml. In a round-bottom flask was placed 10.4 g of the polymer thus obtained, and the air in the flask was replaced by nitrogen, after which 400 ml of chloromethyl methyl ether was added. The resulting mixture was stirred to form a homogeneous solution. Subsequently, 4.0 ml of tin tetrachloride dissolved in 50 ml of chloromethyl methyl ether was dropped thereinto, and the resulting mixture was subjected to reaction for 60 min. The reaction product was poured into methanol containing 2,2'-methylene-bis(6-t-butyl-4-ethylphenol) to separate the product, which was then recovered.

In the same manner as in Example 1, the structure of the product was analyzed to find that 80% of the styrene unit and 30% of the recurring unit (A-2) were contained. The chlorine content was 6.21% by weight, and the number average molecular weight ws 2.0 x 10⁵ as measured by a membrane osmometer.

In the same manner as in Example 1, the product obtained above was formed into a solution, and subsequently, this solution was coated on a silicon wafer having a thermally oxidized layer in the same manner as in Example 1. Further, the relation between the yield of residual resist thickness and the irradiation energy of electron beams was investigated in the same manner as in Example 3 to obtain the result shown in the accompanying drawings. The irradiation energy at the gel point was 0.8 µC/cm² which was lower in sensitivity than Examples 3 and 4.

## Claims

1. An ionizing radiation-sensitive resist comprising a polymer having a recurring unit represented by the general formula (A): 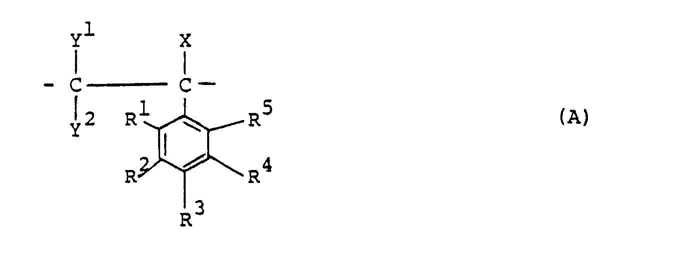 wherein:
X, Y¹ and Y² are the same or different and each represents a hydrogen atom, a methyl group or a halogen atom; and
R¹, R², R³, R⁴ and R⁵ are the same or different and each represents a hydrogen atom, a halogen atom, a C₁-C₃ alkyl group, a C₁-C₃ alkoxy group, a C,-C₃ haloalkyl group or a C₁-C₃ haloalkoxy group, provided that at least some of the groups represented by X in said polymer are halogen atoms, at least some of the groups represented by Y¹ and/or ^{y2} are halogen atoms, at least some of the groups represented by R¹, R², R³, R⁴ and R⁵ are haloalkyl or haloalkoxy groups, and the halogen content of said polymer is from 1 to 50% by weight.

2. A resist according to Claim 1, in which the number average molecular weight of said polymer is from 10,000 to 1,500,000.

3. A resist according to Claim 1 or Claim 2, in which the halogen content of said polymer is from 1 to 25% by weight.

4. A resist according to Claim 1 or Claim 2, in which the halogen content of said polymer is from 5 to 50% by weight.

5. A resist according to any one of the preceding Claims, wherein said polymer comprises the following recurring units:
(A―1), which is a recurring unit of formula (A) in which X represents a halogen atom;
(A-2), which is a recurring unit of formula (A) in which at least one of the groups represented by R¹, R², R³, R⁴ and R⁵ is a C₁-C₃ haloalkyl group or a C₁-C₃ haloalkoxy group; and
(A-3), which is a recurring unit of formula (A) in which at least one of the groups represented by Y¹ and Y² is a halogen atom,

the total proportion of units (A-1), (A-2) and (A-3) being from 7 to 70% of the recurring units in the polymer.

6. A process for preparing the ionizing radiation-sensitive resist according to any one of the preceding claims, which comprises halogenating, under free radical conditions, a polymer comprising a recurring unit of general formula (B): 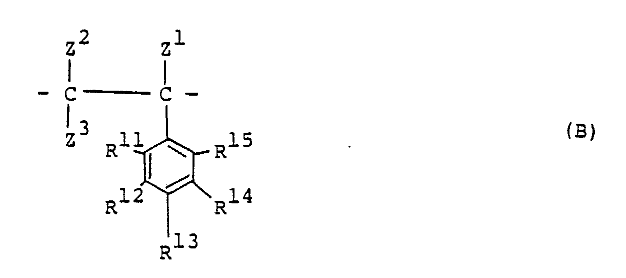 in which:
R¹¹, R¹², R¹³, R¹⁴ and R¹⁵ are the same or different and each represents a hydrogen atom, a C₁-C₃ alkyl group or a C₁-C₃ alkoxy group, provided that R¹¹, R¹², R¹³, R¹⁴ and R¹⁵ do not simultaneously all represent hydrogen atoms; and
Z¹, Z² and Z³ are the same or different and each represents a hydrogen atom, a fluorine atom or a methyl group, provided that, when Z¹ represents a methyl group, Z² and Z³ both represent hydrogen atoms and optionally comprising a recurring unit of formula (C): 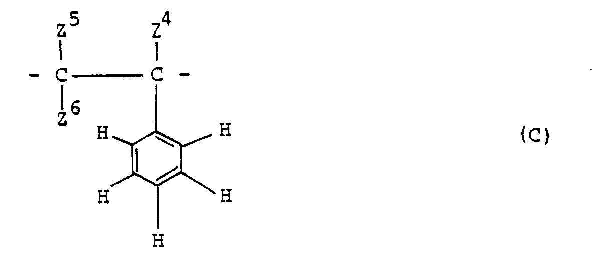 in which Z⁴, Z⁵ and Z⁶ are the same or different and each represents a hydrogen atom, a fluorine atom or a methyl group, provided that, when Z¹ of the recurring unit of formula (B) represents a methyl group, Z⁴ represents a hydrogen atom, to form a halogenated polymer having a halogen content of from 1 to 50% by weight.

7. A process according to Claim 6, in which said polymer contains from 20 to 100% of recurring units represented by formula (B), from 0 to 70% of recurring units of formula (C) and from 0 to 50% of other recurring units.

8. A process according to Claim 6 or Claim 7, in which the halogen content of said polymer is from 1 to 25% by weight.

9. A process according to Claim 6 or Claim 7, in which the halogen content of said polymer is from 5 to 50% by weight.

10. A process for forming a pattern, which comprises the steps:
(1) forming a coating film of an ionizing radiation-sensitive resist on a substrate;
(2) irradiating the desired parts of said coating film with ionizing radiation;
(3) treating said coating film with a developing agent; and
(4) treating said coating film with a rinsing agent, characterized in that said ionizing radiation-sensitive resist is as defined in any one of claims 1 to 5 or is prepared by a process as claimed in any one of claims 6 to 9.

## Patentansprüche

1. lonisierender strahlungsempfindlicher Resist, enthaltend ein Polymer mit wiederkehrenden Einheiten der allgemeinen Formel (A): 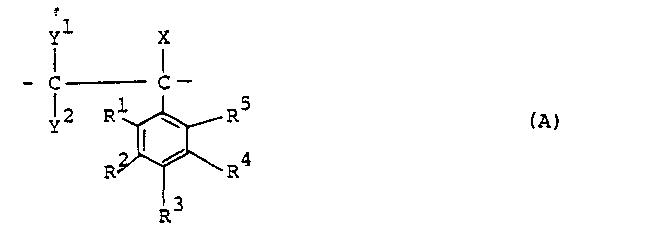 in der bedeuten:
X, X¹ und Y², gleich oder verschieden, je Wasserstoff, Methyl oder Halogen und
R¹, R², R³, R⁴ und R⁵, gleich oder verschieden, je Wasserstoff, Halogen, C₁-C₃-alkyl, C₁-C₃-Alkoxy, C₁-C₃-Halogenalkyl oder C₁-C₃-Hafogenalkoxy, mit der Maßgabe, daß mindestens einige der Reste X in dem Polymer Halogen, mindestens einige der Reste Y¹ und/oder Y² Halogen, mindestens einige der Reste R¹, R², R³, R⁴ und R⁵ Halogenalkyl oder Halogenalkoxy sind und der Halogengehalt des Polymers von 1 bis 50 Gew.-% beträgt.

2. Resist nach Anspruch 1, in dem das mittlere Zahlen-Molekulargewicht des Polymers von 10 000 bis 1 500 000 beträgt.

3. Resist nach Anspruch 1 oder 2, in dem der Halogengehalt des Polymers von 1 bis 25 Gew.-% beträgt.

4. Resist nach Anspruch 1 oder 2, in dem der Halogengehalt des Polymers von 5 bis 50 Gew.-% beträgt.

5. Resist nach einem der vorhergehenden Ansprüche, in dem das Polymer folgende wiederkehrende Einheiten enthält: (A-1): wiederkehrende Einheit der Formel (A), in der X Halogen ist, (A-2): wiederkehrende Einheit der formel (A), in der mindestens einer der Rest R¹, R², R³, R⁴ und R⁵, C₁-C₃-Halogenalkyl oder C₁-C₃-Halogenalkoxy ist, und (A-3): wiederkehrende Einheit der Formel (A), in der mindestens einer der Reste Y¹ und Y² Halogen ist, wobei die Gesamtmenge an Einheiten (A-1), (A-2) und (A-3) von 7 bis 70% der wiederkehrenden Einheiten des Polymers ausmacht.

6. Verfahren zur Herstellung des ionisier enden strahlungsempfindlichen Resists nach einem der vorhergehenden Ansprüche, gekennzeichnet durch Halogenierung unter Bildung von freien Radikalen eines Polymers mit wiederkehrenden Einheiten der allgemeinen Formel (B): 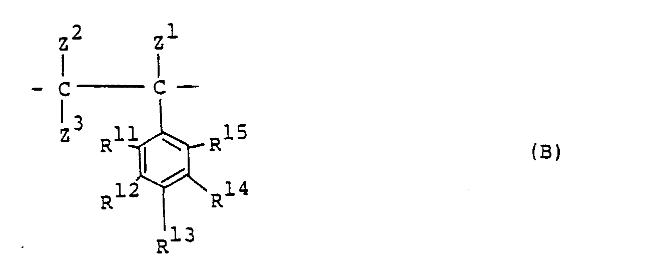 in der bedeuten: R¹¹, R¹², R¹³, R¹⁴ und R¹⁵, gleich oder verschieden, je Wasserstoff, C₁-C₃-Alkyl oder C₁-C₃-Alkoxy, mit der Maßgabe, daß R¹¹, R¹², R¹³, R¹⁴ und R¹⁵, nicht alle gleichzeitig Wasserstoff sind, und
Z¹, Z² und Z³, gleich oder verschieden, je Wasserstoff, Fluor oder Methyl, mit der Maßgabe, daß wenn Z¹ Methyl ist, Z² und Z³ je Wasserstoff sind, und mit gegebenenfalls wiederkehrenden Einheiten der Formel (C): 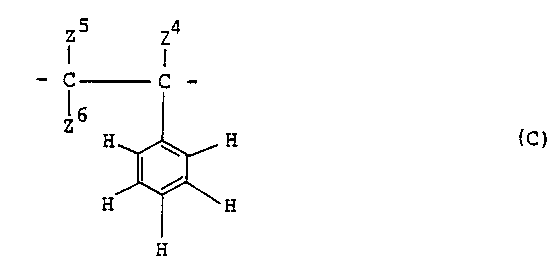 in der bedeuten:
Z⁴, Z5 und Z⁶, gleich oder verschieden, je Wasserstoff, Fluor oder Methyl, mit der Maßgabe, daß, wenn Z¹ der wiederkehrenden Einheit der Formel (B) Methyl ist, Z⁴ Wasserstoff ist, zu einem halogenierten Polymer mit einem Halogengehalt von 1 bis 50 Gew.-%.

7. Verfahren nach Anspruch 6 zur Herstellung eines Polymers, das von 20 bis 100% wiederkehrende Einheiten der Formel (B), von 0 bis 70% wiederkehrende Einheiten der formel (C) und von 0 bis 50% andere wiederkehrende Einheiten enthält.

8. Verfahren nach Anspruch 6 oder 7 zur Herstellung eines Polymers mit einem Halogengehalt von 1 bis 25 Gew.-%.

9. Verfahren nach Anspruch 6 oder 7 zur Herstellung eines Polymers mit einem Halogengehalt von 5 bis 50 Gew.-%.

10. Verfahren zur Herstellung eines Bildmusters mit folgenden Stufen:
(1) Herstellen eines Beschichtungsfilms eines ionisierenden strahlungsempfindlichen Resists auf einem Substrat,
(2) Bestrahlen der gewünschten Bereiche des Beschichtungsfilms mit ionisierenden Strahlen,
(3) Entwickeln des Beschichtungsfilms mit einem Entwickler und
(4) Spülen des Beschichtungsfilms mit einem Spülmittel, gekennzeichnet durch Verwendung eines ionisierenden strahlungsempfindlichen Resists gemäß einem der Ansprüche 1 bis 5 oder hergestellt gemäß dem Verfahren nach·einem der Ansprüche 6 bis 9.

## Revendications

1. Resist sensible aux radiations ionisantes, comprenant un polymère possédant un motic repété représenté par la formule générale (A): 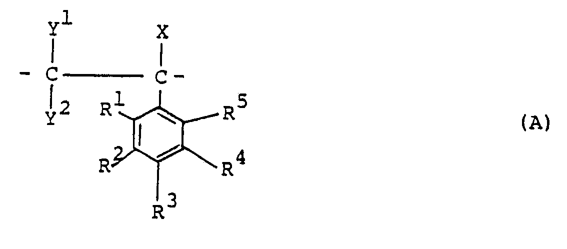 dans laquelle
X, Y¹ et Y² sont identiques ou différents, et représentent chacun un atome d'hydrogène, un groupe méthyle ou un atome d'halogène; et
R¹, R², R³, R⁴ et R⁵ sont identiques ou différents, et représentent chacun un atome d'hydrogène, un atome d'halogène, un groupe alkyle en C₁-C₃, un groupe alcoxy en C₁-C₃, un groupe halogénoalkyle en C₁-C₃ ou un groupe halogénoalkcoxy en C₁-C₃; étant entendu qu'au moins certains des groupes représentés par X dans ledit polymère sont des atomes d'halogène, au moins certains des groupes représentés par Y² et/ou Y² sont des atomes d'halogène, au moins certains des groupes représentés par R¹, R², R³, R⁴ et R^{S} sont des groupes halogénoalkyle ou halogénoalcoxy, et la teneur en halogène dudit polymère est de 1 à 50% en poids.

2. Resist selon la revendication 1, dans lequel la masse moléculaire moyenne en nombre dudit polymère va de 10 000 à 1 500 000.

3. Resist selon la revendication 1 ou 2, dans lequel la teneur en halogène dudit polymère est de 1 à 25% en poids.

4. Resist selon la revendication 1 ou 2, dans lequel la teneur en halogène dudit polymère est de 5 à 50% en poids.

5. Resist selon l'une quelconque des revendications précédentes, dans lequel ledit polymére comprend les motifs répétés suivants:
(A-1), qui est un motif répété de formule (A) dans lequel X représente un atome d'halogène;
(A-2), qui est un motif répété de formule (A) dans lequel au moins un des groupes représentés par R1, R², R³, R⁴ et R⁵ est un groupe halogénoalkyle en C₁-C₃ ou un groupe halogénoalcoxy en C₁-C₃; et
(A-3), qui est un motif répété de formule (A) dans lequel au moins un des groupes représentés par Y¹ et Y² est un atome d'halogène;
la proportion totale des motifs (A-1), (A-2) et (A-3) étant de 7 à 70% des motifs répétés dans le polymère.

6. Procédé pour la préparation du resist sensible aux radiations ionisantes selon l'une quelconque des revendications précédentes, lequel comprend l'halogénation, dans des conditions de radicaux libres, d'un polymère comprenant un motif répété de formule générale (B): 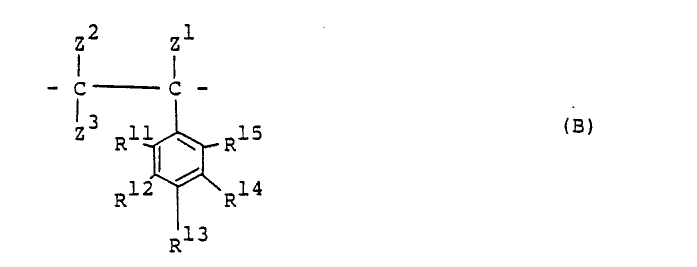 dans laquelle
R¹¹, R¹², R¹³, R¹⁴ et R¹⁵ sont identiques ou différents, et représentent chacun un atome d'hydrogène, un groupe alkyle en C₁-C₃ ou un groupe alcoxy en C₁-C₃, étant entendu que R¹¹, R¹², R¹³, R¹⁴ et R¹⁵ ne représentent pas tous en même temps des atomes d'hydrogène; et
Z¹, Z² et Z³ sont identiques ou différents, et représentent chacun un atome d'hydrogène, un atome de fluor ou un groupe méthyle, étant entendu que lorsque Z¹ représente un groupe méthyle, Z² et Z³ représentent l'un et l'autre des atomes d'hydrogène, et comprenant éventuellement un motif répété de formule (C): 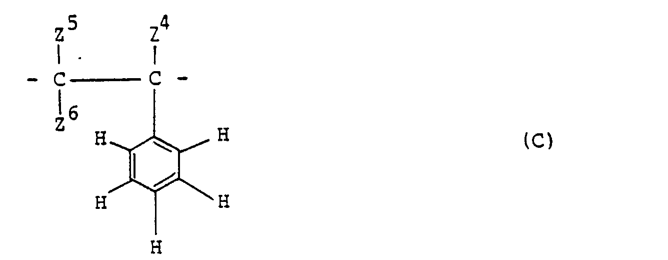 dans laquelle
Z⁴, Z^{S} et Z^{e} sont identiques ou différents et représentent chacun un atome d'hydrogène, un atome de fluor ou un groupe méthyle, étant entendu que lorsque le radical Z¹ du motif répété de formule (B) représente un groupe méthyle, Z⁴ représente un atome d'hydrogène, pour la formation d'un polymère halogéné ayant une teneur en halogène allant de 1 à 50% en poids.
7. Procédé selon la revendication 6, dans lequel ledit polymère contient de 20 à 100% de motifs répétés représentés par la formule (B), de 0 à 70% de motifs répét de formule (C) et de 0 à 50% d'autres motifs répétés.

8. Procédé selon la revendication 6 ou 7, dand lequel la teneur en halogène dudit polymère est de 1 à 25% en poids.

9. Procédé selon la revendication 6 ou 7, dans lequel la teneur en halogène dudit polymère est de 5 à 50% en poids.

10. Procédé pour la formation d'un motif, lequel comprend les étapes de:
(1) formation d'une pellicule de revêtement, constituée d'un resist sensible aux radiations ionisantes, sur un support;
(2) irradiation des parties désirées de ladite pellicule de revêtement avec un rayonnement ionisant;
(3) traitement de ladite pellicule de revêtement par un agent de développement; et
(4) traitement de ladite pellicule de revêtement par un agent de rinçage, caractérisé en ce que ledit resist sensible aux radiations ionisantes est tel que défini dans l'une quelconque des revenications 1 à 5, ou est préparé par un procédé selon l'une quelconque des revendications 6 à 9.
